# EUROPÄISCHE PATENTSCHRIFT

(11) **EP 0 946 792 B1**
(45) Veröffentlichungstag und Bekanntmachung des Hinweises auf die Patenterteilung: **02.05.2003**
(21) Anmeldenummer: 97912034.2
(22) Anmeldetag: 29.09.1997
(51) Int. Cl.: C25D 1/00, C25D 5/02

(54) **VERFAHREN ZUR HERSTELLUNG EINES MIKROMECHANISCHEN BAUELEMENTS**
PRODUCTION PROCESS FOR A MICROMECHANICAL BUILDING COMPONENT
PROCEDE DE FABRICATION D'UN ELEMENT DE CONSTRUCTION MICROMECANIQUE

(30) Priorität: 09.10.1996 DE 19641531
(43) Veröffentlichungstag der Anmeldung: 06.10.1999
(73) Patentinhaber: ROBERT BOSCH GMBH, 70442 Stuttgart (DE)
(72) Erfinder: MAGENAU, Horst, D-70839 Gerlingen (DE); SCHATZ, Frank, D-70806 Kornwestheim (DE); GLOCK, Armin, D-73655 Plüderhausen (DE); KRAUSS, Elke, D-71254 Ditzingen (DE); SCHITTNY, Thomas, D-71711 Steinheim (DE); JAUERNIG, Alexandra, D-71229 Leonberg (DE); GLAS, Ronald, D-38106 Braunschweig (DE)
(86) Internationale Anmeldenummer: DE9702230
(87) Internationale Veröffentlichungsnummer: WO98015676

(56) Entgegenhaltungen:
- US-A- 5 080 763
- US-A- 5 194 402
- US-A- 5 387 495
- MINAMI K ET AL: "FABRICATION OF DISTRIBUTED ELECTROSTATIC MICRO ACTUATOR (DEMA)" JOURNAL OF MICROELECTROMECHANICAL SYSTEMS, Bd. 2, Nr. 3, 1.September 1993, Seiten 121-127, XP000426532

## Beschreibung

### Stand der Technik

Die Erfindung betrifft ein Verfahren zur Herstellung eines mikromechanischen Bauelements, das aus mehreren Schichten, beispielsweise aus elektrisch leitenden und nichtleitenden Schichten oder Bereichen bzw. aus Lagen oder Bereichen aus metallischen und nichtmetallischen Werkstoffen, aufgebaut ist, nach dem Oberbegriff des Hauptanspruchs.

Aus der US 5,194,402 ist ein Mikrosensor als mikromechanisches Bauelement bekannt, bei dem Bauelementstrukturen aus übereinander angeordneten Schichten gewonnen worden sind. Hierbei wurde unter anderem eine Kupferschicht als Sputterschicht für eine Startmetallisierung für eine darüber anzuordnende Galvanikschicht benutzt.

Weiterhin ist aus der US 5,080,763 bekannt, dass zur Herausbildung von Leiterbahnstrukturen bei einem Halbleiterbauelement Sputterschichten für aufzubringende Galvanikschichten benutzt werden. Die unterschiedlichen Strukturen wurden bei dieser bekannten Anordnung durch ein kontinuierliches Sputterverfahren der aufeinanderfolgenden Schichten erzeugt.

Bei einem in der DE-OS 39 19 876 beschriebenen, als Mikroventil verwendeten Bauelement sind einzelne Schichten im Aufbau des Mikroventils mit mikromechanischen Fertigungsmethoden bearbeitet. Hierbei wird beispielsweise die Oberfläche eines Silizium-Wafers fotolithographisch strukturiert und durch anschließende Ätzung werden vorgegebene Bereiche teilweise entfernt, so dass die gewünschten mechanischen Elemente durch eine strukturierte dreidimensionale Bearbeitung dieser Schichten herausgebildet werden.

Als Fertigungsverfahren sind beispielsweise die UV-Tiefenlithographie für die Strukturierung der nichtleitenden Bereiche und die Mehrlagengalvanik für Herstellung von metallischen, leitenden Bereichen für sich gesehen bekannt. Hierbei ist auch auf nichtleitenden Trägerschichten eine leitfähige Startschicht für die spätere außenstrombehaftete galvanische Metallabscheidung in den jeweiligen Bereichen notwendig.

Bekannt sind als Startmetallisierung ganzflächig auf nichtleitende Substrate als Trägerschicht aufgetragene leitende metallische Schichten. Diese Startschichten können durch Lackieren (Sprühen, Tauchen, Schleudern etc.) oder mit Hilfen verschiedener nasschemischer Verfahren oder durch PVD-Verfahren (Bedampfen, Sputtern etc.) (PVD = Physical Vapor Deposition) aufgetragen werden. Sie weisen entweder eine eigene elektrische Leitfähigkeit auf, die für die außenstrombehaftete Galvanisierung hinreicht, oder sie dient als Bekeimungsschicht für eine außenstromlos abgeschiedene Metallschicht, die dann wiederum als Startschicht für die folgende außenstrombehaftete Mehrlagengalvanik dient.

Weiterhin sind nasschemische Verfahren (DMS-E-Verfahren) zur strukturierten Bearbeitung von Oberflächen aus der Leiterplattentechnik bekannt (EP 0 206 133 A1), beispielsweise um in die Leiterplatte gebohrte Löcher leitfähig zu machen. Hier wird eine Startschicht strukturiert bzw. selektiv auf die nichtleitenden Bereiche der Leiterplattenoberfläche aufgebracht, so dass wiederum die gesamte Oberfläche elektrisch leitfähig wird. Diese Bearbeitungsverfahren sind jedoch zu den Prozessen der UV-Tiefenlithographie und Mehrlagengalvanik nicht kompatibel, da sie zu grob sind.

Es sind auch Verfahren bekannt, die es erlauben zwei Metallschichten an einer Zwischenschicht trennbar zu machen. Hierbei wird die Zwischenschicht selektiv zu den übrigen Werkstoffen durch Ätzen oder Lösen als Opferschicht entfernt. Diese Verfahren hinterlassen zwischen den zu trennenden

Schichten Spalte von einigen µm Dicke, was insbesondere dann nachteilig ist, wenn gut aufeinander passende Oberflächen zu fertigen sind, die auch als Dichtflächen genutzt werden sollen.

### Vorteile der Erfindung

Das erfindungsgemäße Herstellungsverfahren für ein mikromechanisches Bauelement der eingangs genannten Art ist in der Weiterbildung mit den Merkmalen des Hauptanspruchs dadurch vorteilhaft, dass für die Mehrlagengalvanik Startmetallisierungen aufgebracht werden, die zu den übrigen Prozessen und Werkstoffen der UV-Tiefenlithographie und

Mehrlagengalvanik kompatibel sind. Die erfindungsgemäße Startmetallisierung ermöglicht es, die neue Galvanoschicht haftfest auf der jeweils unten liegenden abzuscheiden und damit dreidimensional strukturierte Bauelemente in Schichtbauweise zu ermöglichen.

Vorteilhaft ist insbesondere das erfindungsgemäße Herstellungsverfahren für die mikromechanischen Bauelemente gegenüber den bisher bekannten Prozessen insbesondere für die Startmetallisierung eines Substrates mit elektrisch leitenden und nichtleitenden Bereichen aus folgenden Gründen:
1. Es werden Sputterprozesse bei Substrattemperaturen von weniger als 100°C oder nasschemische Prozesse in einem PH-Bereiche unterhalb von PH 8,5 (ganz schwach alkalisch oder sauer) verwendet, die mit den Werkstoffen und Herstellungsprozessen der UV-Tiefenlithographie kompatibel sind. Die Resiste der nichtleitenden Bereiche bleiben also während der Herstellungsschritte auf dem Substrat haften und lassen sich am Ende der Prozesskette bei Bedarf mit den üblichen Verfahren entfernen.
2: Die metallischen Oberflächen der leitenden Bereiche werden durch die einzelnen Verfahrensschritte nur so weit chemisch passiviert, dass sie vor jeder neuen Beschichtung erforderlichenfalls wieder mit Standardverfahren aktiviert werden können, zur Aufnahme weiterer Metallschichten. Nur so kann gewährleistet werden, dass die aufeinander abgeschiedenen metallischen Galvanoschichten untereinander eine gute Haftung aufweisen.
3: Die Strukturierung der Sputterschicht wird über einen Ätzprozess der unteren Galvanikschicht durchgeführt. Hiermit ist sichergestellt, dass die Bekeimungs- bzw. Startschicht die nichtleitenden Bereiche mit hoher Genauigkeit überdeckt und die metallischen Bereiche des Substrats unverändert bleiben. Die Haftung der Galvanikschichten aufeinander kann daher so gut sein wie die Haftung von zwei unstrukturiert aufeinander abgeschiedenen Galvanikschichten.

Gemäß einer weiteren Ausführungsform wird die Startmetallisierung derart gestaltet, dass in bestimmten Bereichen des Substrates als Ausgangsschicht eine Lage mit einer geringen Haftung vorhanden ist. In diesen Bereichen kann dann die obere Galvanoschicht von der unteren abgehoben werden und es können bewegliche Komponenten mit einem beliebig engen Spalt zwischen ihren Berührungsflächen geschaffen werden. Beispiele sind Dichtelemente für fluidische Anwendungen oder Schaltelemente, die im nicht aktuierten Zustand geschlossen sind.

Das erfindungsgemäße Herstellungsverfahren erlaubt insbesondere eine Weiterentwicklung der Fertigungsverfahren mit UV-Tiefenlithographie und Mehrlagengalvanik zur Herstellung von Bauelementen mit dreidimensionaler Strukturen und mit Hinterschneidungen. Dies wird ermöglicht durch die elektrisch leitenden Zwischenschichten, die es ermöglichen, Metalle elektrolytisch, d.h. außenstrombehaftet auf Oberflächen mit Strukturen aus Metall sowie elektrisch isolierendem Kunststoff abzuscheiden. Die metallischen Bereiche der jeweiligen Oberfläche der Schichten bestehen in der Regel aus einer unteren Galvanoschicht, die isolierenden Bereiche aus einem fotostrukturierten Resist (z.B. Polyimid, AZ-Lack (Fotolack) oder Festresiste).

Anwendungen des erfindungsgemäßen Bauelements sind dreidimensionale Mikrobauelemente aus Metall mit Hinterschneidungen wie beispielsweise Turbulenzdüsen für die Gemischaufbereitung bei Ottomotoren oder auch Mikrosensoren oder Bauelemente, die zusätzlich bewegliche Strukturen aufweisen wie Mikroventile, Mikrorelais, Mikroschalter oder Mikromotoren.

Vorteilhafte Weiterbildungen der erfindungsgemäßen Ausführungsformen sind in den weiteren Unteransprüchen angegeben.

### Zeichnung

Ein Ausführungsbeispiel eines erfindungsgemäß hergestellten Bauelementes wird anhand der Zeichnung erläutert. Es zeigen:
Figur 1 eine Draufsicht auf ein Substrat als Trägerschicht mit einer ersten Schicht mit leitenden und nichtleitenden Bereichen;
Figur 2 einen Schnitt durch Teilbereiche des Substrats nach Figur 1;
Figur 3 Schnitte durch mehrere Schichten auf dem Substrat in den aufeinanderfolgenden Herstellungsschritten nach einer ersten Ausführungsform und
Figur 4 Schnitte durch mehrere Schichten auf dem Substrat in den aufeinanderfolgenden Herstellungsschritten nach einer zweiten Ausführungsform.

### Beschreibung der Ausführungsbeispiele

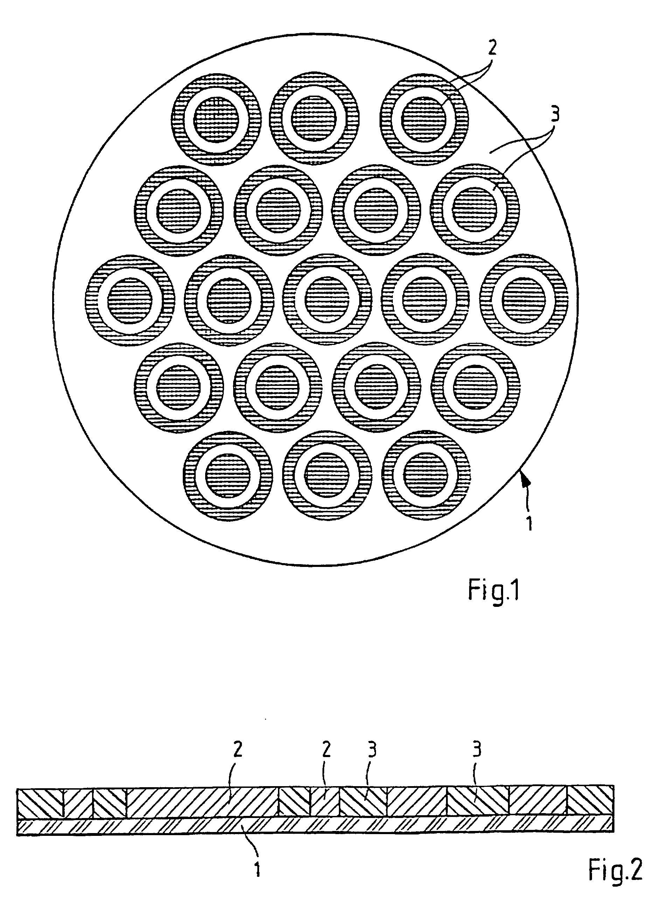

Aus Figur 1 ist die Grundlage für Herstellung eines mikromechanischen Bauelements ersichtlich, nämlich ein Substrat 1 als Trägerschicht für weitere aufzubringende Schichten. Das Substrat kann Metall, Silizium, Keramik oder Glas sein; beim hier beschriebenen Ausführungsbeispiel ist es aus Glas. Die üblichen Dicken dieses Substrats betragen zwischen 500 µm und 2 mm und es müssen, um insbesondere außenstrombehaftete galvanische Prozesse zu ermöglichen, gut haftende metallische Startschichten aufgetragen werden.

In der Ausgangslage wird das Substrat 1 in bekannter Weise mit leitenden Bereichen 2 und mit nichtleitenden Bereichen 3 versehen. Hierzu wird das Substrat mit einem Resist (z.B. Polyimid, AZ-Lack oder Festresist) beschichtet durch Aufschleudern, Sprühen oder Laminieren. Der Resist wird mit der gewünschten Struktur belichtet und entwickelt. An den offenen Stellen des Lacks (Resist) wird dann Metall galvanisch abgeschieden. Die leitenden Bereiche 2 der unteren Galvanikschicht bestehen aus einem metallischen Werkstoff (z.B. Kupfer oder Nickel), die nichtleitenden Bereiche 3 aus dem Resist. In Figur 2 sind diese Bereiche 2 und 3 im Schnitt zu erkennen.

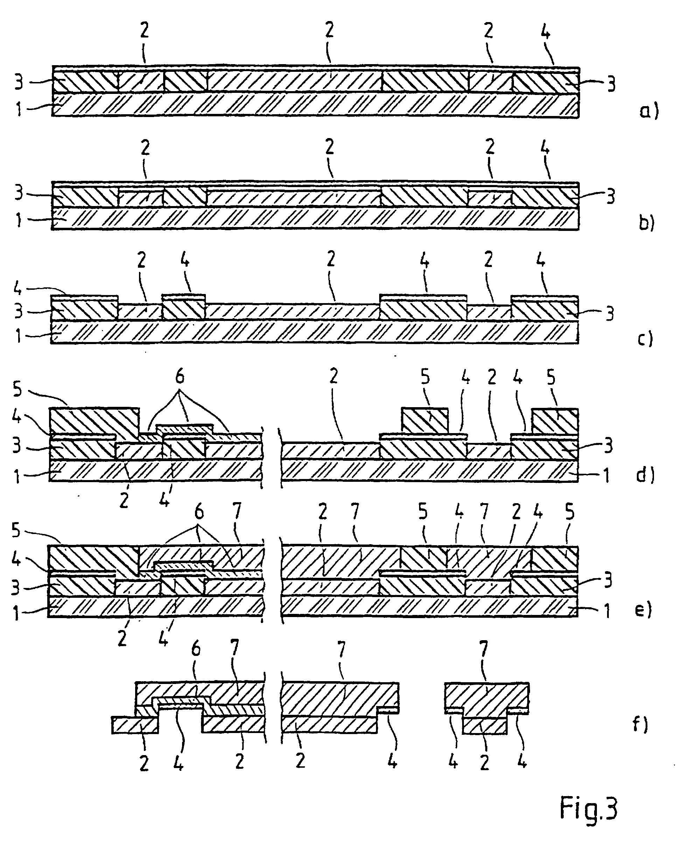

Anhand der Schnittdarstellungen nach Figur 3 werden die nachfolgenden Herstellungsschritte erläutert. In einem ersten Herstellungsschritt (Ansicht a) wird die gesamt Oberfläche des Substrats 1 mitsamt den Bereichen 2 und 3 mit einer Schicht 4 aus Silber, Palladium oder Platin besputtert; beim beschriebenen Ausführungsbeispiel ist diese Schicht aus Palladium.

Der Prozess des Sputterns ist an sich bekannt; hier wird aus einem ionisierten Gas (z.B. Argon) das sogenannte Target mit energiereichen Ionen beschossen. Aus dem Target werden durch den lonenbeschuss Atome und/oder Moleküle herausgeschlagen und mit 1/100 der kinetischen Energie der Ionen auf das Substrat 1 beschleunigt. Auf dem Substrat 1 entsteht somit eine dünne sehr gleichmäßige neue Oberflächenschicht. Die Dicke der Schicht 4 beträgt einige Nanometer, wenn diese Sputterschicht 4 als Bekeimungsschicht für eine anschließend außenstromlos (d.h. durch Metallabscheidung) aufgetragene metallische Startschicht fungieren soll, und 5 nm bis 100 nm, wenn die Sputterschicht 4 selbst als Startschicht für folgende außenstrombehaftete galvanische Prozesse dienen soll.

In einem zweiten Herstellungsschritt nach Ansicht b) wird die untere Metallschicht in den leitenden Bereichen 2 durch die relativ poröse Sputterschicht 4 hindurch angeätzt. Dieser Schritt wird vorteilhaft mit einem in der sogenannten Mehrlagengalvanik für sich gesehen bekannten Standardprozess (elektrolytische Aktivierung) durchgeführt, bei dem die bisher entstandene Anordnung mit einen nicht passivierenden Elektrolyten (z.B. C1-Ionen haltiges Ni-Strike-Bad) behandelt wird, wobei dann die leitenden Bereiche 2 um einige Mikrometer unter der Sputterschicht 4 anodisch abgetragen werden.

Die Sputterschicht 4 wird bei diesem Herstellungsschritt nicht abgetragen, sie verliert aber die Haftung zur unteren Metallschicht der Bereiche 2 und kann in einem Spülschritt von dieser Metallschicht abgelöst und entfernt werden. Die nichtleitenden Bereiche 3 sind somit passgenau beschichtet, ohne dass eine mit neuen lateralen Toleranzen behaftete fotolithographische Strukturierung erforderlich gewesen wäre (Ansicht c) der Figur 3).

Um eine weitere strukturierte Schicht aufzubringen wird wiederum ein fotostrukturierbarer weiterer Resist 5 aufgetragen, belichtet und entwickelt, so dass die nichtleitenden Bereiche 5 des weiteren Resists stehen bleiben (Ansicht d) der Figur 3).

Beim nächsten, ebenfalls aus der Ansicht d) der Figur 3 ersichtlichen Herstellungsschritt werden die freiliegenden Bereiche der Sputterschicht 4 sowie die freiliegenden Bereiche der unteren Galvanikschicht 2 chemisch, d.h. in einer Redoxreaktion außenstromlos mit einem Metall (z.B. Nickel) verstärkt bzw. beschichtet (ersichtlich nur im linken Teil der Ansicht d)). Zuvor wird jedoch die untere Galvanoschicht (Bereiche 2) durch anodisches Abtragen noch einmal aktiviert und die Sputterschicht 4 in einem reduzierenden Bad (z.B. mit Natriumborhydrid) ebenfalls aktiviert. Auf den so aktivierten Flächen kann nun außenstromlos Metall zur Verstärkung der Sputterschicht 4 abgeschieden werden. Das gleichzeitig auf der unteren Galvanikschicht ebenfalls chemisch abgeschieden wird, stört hier nicht, wenn ein sehr ähnlicher Werkstoff für die Galvanikschicht und die chemisch abgeschiedene Schicht verwendet wird.

Auf die chemisch abgeschiedenen Schicht 6 kann nun mit einem in der Mehrlagengalvanik üblichen Verfahren außenstrombehaftet eine obere metallische Galvanoschicht 7 aufgetragen werden, so dass sich die Anordnung nach Ansicht e) der Figur 3 ergibt.

Die metallischen Galvanoschichten 2 und 7 haften somit über der chemisch abgeschiedenen Schicht 6 aneinander und können nach einer Ablösung vom Substrat 1 und der Entfernung der Resistschichten 3 und 5, gemäß Ansicht f) der Figur 3, ein mikromechanisches Bauelement mit komplexen Strukturen einschließlich Hinterschneidungen bilden.

Alternativ kann bei der dickeren Variante der Sputterschicht 4 (5 nm - 100 nm) nach dem Aktivierungsschritt direkt die Galvanikschicht 7 abgeschieden werden (rechte Seite von Fig. 3d) und 3e)).

Beim, anhand des Ausführungsbeispiels beschriebenen Herstellungsverfahren ist zu beachten, dass die oben beschriebenen Teilprozesse nass in nass erfolgen, denn die metallischen Oberflächen der Bereiche 2 und der Sputterschicht 4 (bzw. Schicht 6) dürfen zwischen den einzelnen Herstellungsschritten nicht mit ungebundene Sauerstoff in Berührung kommen. Sie würden dann wieder oxidiert und damit passiviert und zur Aufnahme weiterer Metallschichten nicht geeignet sein.

Der Werkstoff der außenstromlos abgeschiedenen Metallschicht 6 sollte wegen der erwünschten chemischen Homogenität und einer besseren Haftung der Schichten 2, 6, und 7 aufeinander dem elektrolytisch abgeschiedenen Metall der Schichten 2 und 7 chemisch möglichst ähnlich sein. Bei einer dickeren Sputterschicht 4 kann auf die außenstromlos aufgetragene metallische Verstärkung jedoch verzichtet werden (wie oben beschrieben).

Der Fotoresist der Bereiche 5 für die Strukturierung der oberen Galvanoschicht 7 wird vorzugsweise vor der Aktivierung der unteren Metallschicht in den Bereichen 2 und der Sputterschicht 4 aufgetragen werden. Der Vorteil besteht darin, dass der Aktivierungsschritt nur einmal durchgeführt werden muss. Nachteilig ist, dass die Lackstrukturen des Fotoresists in den Bereichen 5 eventuell unterätzt werden können.

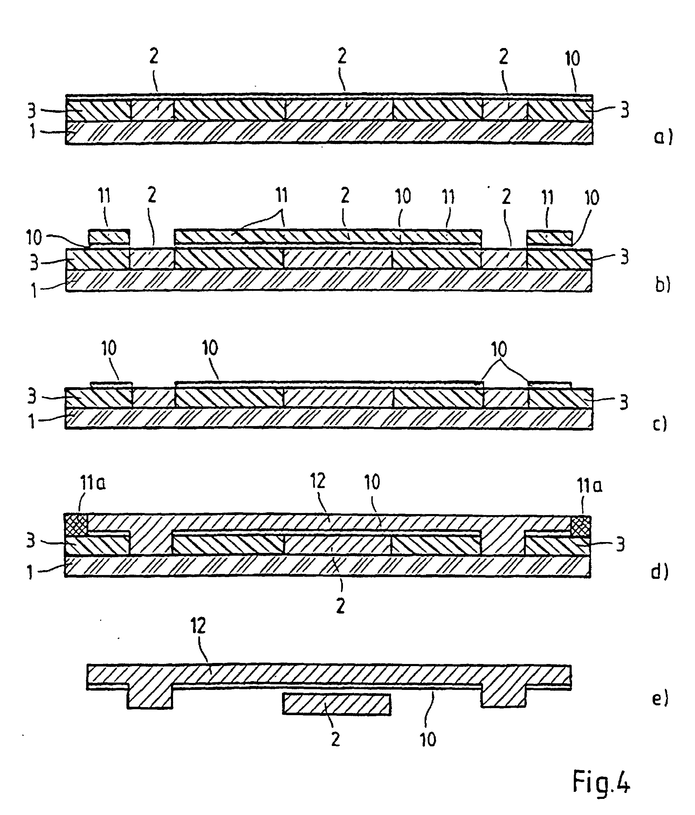

Anhand eines Ausführungsbeispiels gemäß Figur 4 wird ein Herstellungsverfahren mit einer Startschichtmetallisierung für die Galvanikprozesse beschrieben, die es erlaubt, einzelne Bereiche einer oberen metallischen Galvanoschicht von der unteren metallischen Galvanoschicht zu lösen, sie in allen anderen Bereichen aber haftfest auf der unteren Galvanoschicht aufgeschichtet zu lassen.

Das Substrat 1 weist wie beim Ausführungsbeispiel nach Figur 3, Ansicht a) wieder metallische, elektrisch leitende Bereiche 2 neben elektrisch nichtleitenden Bereichen 3 auf. Die metallischen Bereiche 2 können beispielsweise von der unteren Galvanoschicht und die nichtleitenden Bereiche von einem durch die bekannten mit UV-Tiefenlithographie strukturierten Resist gebildet werden.

In einem ersten Herstellungsschritt wird das Substrat 1 ganzflächig, wie oben beschrieben, in diesem Fall jedoch mit Titan besputtert. Die Dicke dieser Sputterschicht 10 beträgt 200 nm bis 400 nm. Der Herstellungsschritt ist so durchzuführen, dass die Titan-Sputterschicht 10 möglichst wenig Sauerstoff enthält und damit auch möglichst wenig stabiles Oxid bildet, denn nur so kann sie im nächsten Prozessschritt durch Ätzen strukturiert werden (Ansicht b)). Es ist deshalb erforderlich, um das Substrat 1 herum vor dem Sputtern ein gutes Vakuum herzustellen und das Substrat 1 zunächst durch einen Ätzvorgang (ebenfalls in Sputtertechnik) zu reinigen. Die untere Galvanoschicht 2 soll hierdurch eine glatte Oberfläche mit geringer Sauerstoff-Oberflächenbelegung aufweisen.

Die aufgesputterte Titanschicht 10 wird gemäß Ansicht b) mit einem fotostrukturierbaren Lack maskiert und in einer Wasserstoff-Fluor-haltigen Lösung (Flusssäure) geätzt. Für die Maskierung wird ein Resist 11 verwendet, der in Medien verarbeitet werden kann, die den Kunststoff bzw. Resist 3 auf dem Substrat 1 nicht angreifen. Nach dem Entfernen dieser Ätzmaske (Bereiche 11) entsteht eine Anordnung gemäß Ansicht c) der Figur 3 und es können die weiteren Prozessschritte der Mehrlagengalvanik durchgeführt werden.

Die folgende in Ansicht d) gezeigte außenstrombehaftete Metallabscheidung und Herstellung der oberen Galvanoschicht 12 wird nach der elektrolytischen Aktivierung der unteren Galvanoschicht 2 durchgeführt. Die Sputterschicht 10 aus Titan wird passiviert und von diesen Prozessen nicht angegriffen. Der Elektrolyt und die Gegenelektrode werden daher nicht mit Titan kontaminiert.

In weiteren Prozessschritten können mehrere Galvanoschichten zwischen strukturierten Resistbereichen 11a gebildet werden. Am Ende der Prozesskette wird der Resist 11a entfernt. Überall dort, wo zwei metallische Galvanoschichten 2, 12 durch eine Titan-Sputterschicht 10 separiert sind, können die beiden Schichten 2 und 12 durch Anlegen einer mechanischen Kraft oder eines Differenzdruckes voneinander getrennt werden.

In den Bereichen 2 auf dem Substrat 1, die nicht von der Titan-Sputterschicht 10 bedeckt sind, bleiben die Eigenschaften der UV-Tiefenlithographie und der Mehrlagengalvanik ebenso wie die Haftung der Galvanikschichten 2 und 12 aneinander erhalten.

Zur Loslösung der beiden Galvanoschichten 2 und 12 in den Bereichen der Sputterschicht 10 muss keine Opferschicht durch langes laterales Ätzen oder Lösen zwischen den zu trennenden Galvanoschichten 2 und 12 entfernt werden. Es entsteht auch kein Spalt zwischen den beiden mechanischen voneinander getrennten Galvanoschichten 2 und 12. Die Oberflächenmorphologie der unteren Galvanoschicht 2 wird auf die obere Galvanoschicht 12 abgebildet, so dass mikromechanische Bauelemente mit bewegten Teilen (Ansicht e)) gefertigt werden können, die dichtend aneinander liegen können.

## Patentansprüche

1. Verfahren zur Herstellung eines mikromechanischen Bauelements mit folgenden Merkmalen,
- das mikromechanische Bauelement weist übereinander angeordnete Schichten aus metallischen Materialien auf, wobei die Schichten zumindest teilweise fest aneinander haften und die Schichten zumindest während des Herstellungsverfahrens über Zwischenschichten (4,6) miteinander verbunden sind, wobei die Zwischenschichten mindestens eine Sputterschicht (4) sind, die als Startmetallisierung auf die jeweils untere metallische Schicht (2) aufgetragen sind und auf die eine obenliegende metallische Galvanikschicht (7) aufbringbar ist, mit folgenden Verfahrensschritten,
- auf einem Substrat (1) wird als Trägerschicht eine erste Schicht mit leitenden (2) und nichtleitenden Bereichen (3) aufgebracht,
- auf die erste Schicht wird eine Sputterschicht (4) als Zwischenschicht aufgebracht,
- die Sputterschicht (4) wird in den leitenden Bereichen (2) aufgrund ihrer Porösität unterätzt und hier anschließend entfernt,
- in vorgegebenen Zonen auf der verbleibenden Sputterschicht (4) und der leitenden Bereiche (2) wird ein oberer Resist (5) aufgebracht,
- in den freien Bereichen zwischen dem Resist (5) wird eine obere metallische Schicht (7) galvanisch aufgebracht und
- in einem späteren Herstellungsschritt werden das Substrat (1), die nichtleitenden Bereiche (3) und der obere Resist (5) entfernt.

2. Verfahren zur Herstellung eines mikromechanischen Bauelements nach Anspruch 1, **dadurch gekennzeichnet, dass**
- die Sputterschicht (4) eine Dicke von 5 nm bis 100 nm aufweist.

3. Verfahren zur Herstellung eines mikromechanischen Bauelements nach Anspruch 1, **dadurch gekennzeichnet, dass**
- zur Herstellung der Zwischenschicht (6) die Sputterschicht (4) eine Dicke von 5 nm bis 10 nm aufweist und chemisch zur Aufnahme von Metall in einer Redoxreaktion aktiviert wird, wobei auch die leitenden Bereiche (2) der unteren Galvanikschicht durch anodisches Abtragen chemisch aktiviert werden und dass
- anschließend die obere Galvanikschicht (7) auf die Zwischenschicht (6) aufgebracht wird.

4. Verfahren zur Herstellung eines mikromechanischen Bauelements nach einem der Ansprüche 1 bis 3, **dadurch gekennzeichnet, daß**
- die Sputterschicht (4) aus Palladium ist.

5. Verfahren zur Herstellung eines mikromechanischen Bauelements mit folgenden Merkmalen,
- das mikromechanische Bauelement weist übereinander angeordnete Schichten aus metallischen Materialien auf, wobei die Schichten zumindest teilweise fest aneinander haften und die Schichten zumindest während des Herstellungsverfahrens über Zwischenschichten (10) miteinander verbunden sind, wobei die Zwischenschichten mindestens eine Sputterschicht (10) sind, die als Startmetallisierung auf die jeweils untere metallische Schicht (2) aufgetragen sind und auf die eine obenliegende metallische Galvanikschicht (7) aufbringbar ist, mit folgenden Verfahrensschritten,
- auf einem Substrat (1) wird als Trägerschicht eine erste Schicht mit leitenden (2) und nichtleitenden Bereichen (3) aufgebracht,
- auf die erste Schicht wird eine Sputterschicht (10) aus Titan als Zwischenschicht aufgebracht,
- die Sputterschicht (10) wird mit einem Resist (11) maskiert,
- die Sputterschicht (10) wird in den nicht maskierten Bereichen weggeätzt und der Resist (11) anschließend entfernt,
- in vorgegebenen Zonen wird ein weiterer Resist (11a) aufgebracht und in den Bereichen zwischen dem weiteren Resist (11a) wird eine obere Galvanikschicht (12) galvanisch aufgebracht und
- in einem späteren Herstellungsschritt werden das Substrat (1), die nichtleitenden Bereiche (3) und der Resist (11a) entfernt und es wird die obere Galvanikschicht (12) an der Sputterschicht (10) von den leitenden Bereichen (2) gelöst.

6. Verfahren zur Herstellung eines mikromechanisehen Bauelements nach Anspruch 5, **dadurch gekennzeichnet, dass**
- der als Maske verwendete Resist (11) für die Sputterschicht (10) ein mit Lösemitteln verarbeiteter Fotolack (AZ-Lack) ist und in einer Lösung aus Flusssäure geätzt wird, wobei die nichtleitenden Bereiche (3) der Trägerschicht aus einem Kunststoff bestehen, der in einem wässrigen alkalischen Medium verarbeitbar ist.

## Claims

1. Process for producing a micromechanical component having the following features,
- the micromechanical component has layers of metallic materials arranged above one another, the layers at least in part being securely bonded to one another and the layers, at least during the production process, being joined to one another via interlayers (4, 6), the interlayers being at least one sputtered layer (4), which are applied as starting metallization to in each case the lower metallic layer (2) and to which an upper metallic electrodeposition layer (7) can be applied, comprising the following process steps,
- a first layer having conductive regions (2) and nonconductive regions (3) is applied as carrier layer to a substrate (1),
- a sputtered layer (4) is applied as interlayer to the first layer,
- the sputtered layer (4) undergoes undercut etching in the conductive regions (2) on account of its porosity and is then removed here,
- an upper resist (5) is applied in predetermined zones to the remaining sputtered layer (4) and the conductive regions (2),
- an upper metallic layer (7) is applied by electrodeposition in the free regions between the resist (5), and
- in a later production step, the substrate (1), the nonconductive regions (3) and the upper resist (5) are removed.

2. Process for producing a micromechanical component according to Claim 1, **characterized in that**
- the sputtered layer (4) has a thickness of 5 nm to 100 nm.

3. Process for producing a micromechanical component according to Claim 1, **characterized in that**
- to produce the interlayer (6), the sputtered layer (4) has a thickness of from 5 nm to 10 nm and is chemically activated to take up metal in a redox reaction, the conductive regions (2) of the lower electrodeposition layer also being chemically activated by anodic removal, and **in that**
- the upper electrodeposition layer (7) is then applied to the interlayer (6).

4. Process for producing a micromechanical component according to one of Claims 1 to 3, **characterized in that**
- the sputtered layer (4) is made from palladium.

5. Process for producing a micromechanical component having the following features,
- the micromechanical component has layers of metallic materials arranged above one another, the layers at least in part being securely bonded to one another and the layers, at least during the production process, being joined to one another via interlayers (10), the interlayers being at least one sputtered layer (10), which are applied as starting metallization to in each case the lower metallic layer (2) and to which an upper metallic electrodeposition layer (7) can be applied, comprising the following process steps,
- a first layer having conductive regions (2)' and nonconductive regions (3) is applied as carrier layer to a substrate (1),
- a sputtered layer (10) made of titanium is applied as interlayer to the first layer,
- the sputtered layer (10) is masked using a resist (11),
- the sputtered layer (10) is then etched away in the unmasked regions and the resist (11) is then removed,
- a further resist (11a) is applied in predetermined zones and an upper electrodeposition layer (12) is applied by electrodeposition in the regions between the further resist (11a), and
- in a later production step, the substrate (1), the nonconductive regions (3) and the resist (11a) are removed, and the upper electrodeposition layer (12) is detached from the conductive regions (2) at the sputtered layer (10).

6. Process for producing a micromechanical component according to Claim 5, **characterized in that**
- the resist (11) used as mask for the sputtered layer (10) is a photoresist processed with solvents (AZ resist) and is etched in a solution of hydrofluoric acid, the nonconductive regions (3) of the carrier layer consisting of a plastic which can be processed in an aqueous alkaline medium.

## Revendications

1. Procédé de fabrication d'un composant micromécanique ayant les caractéristiques suivantes :
- le composant micromécanique comporte des couches superposées de matières métalliques, les couches étant accrochées solidairement au moins en partie et reliées l'une à l'autre par des couches intermédiaires (4, 6) au moins pendant le procédé de fabrication,
les couches intermédiaires étant au moins constituées par une couche pulvérisée (4) appliquée comme métallisation de départ sur chaque couche métallique intérieure (2) et sur laquelle on peut appliquer une couche galvanique métallique supérieure, ayant les étapes suivantes :
- sur un substrat (1), on applique comme couche de support une première couche avec des zones conductrices (2) et des zones non-conductrices (3),
- sur la première couche, on applique une couche de pulvérisation (4) comme couche intermédiaire,
- la couche de pulvérisation (4) est attaquée par en dessous du fait de sa porosité dans les zones conductrices (2) et ensuite on l'enlève,
- on applique un résist supérieur (5) sur les zones qui restent de la couche pulvérisée (4) et sur les zones conductrices (2),
- dans les zones libres, entre le résist (5), on applique par galvanoplastie une couche métallique supérieure (7) et
- dans une autre étape de fabrication, on enlève le substrat (1), les zones non-conductrices (3) et la couche supérieure de résist (5).

2. Procédé de fabrication d'un composant de micromécanique selon la revendication 1,
**caractérisé en ce que**
la couche pulvérisée (4) a une épaisseur de 5 nm jusqu'à 100 nm.

3. Procédé de fabrication d'un composant de micromécanique selon la revendication 1,
**caractérisé en ce que**
- pour réaliser la couche intermédiaire (6), on a une couche pulvérisée (4) ayant une épaisseur de 5 nm jusqu'à 10 nm et on active cette couche chimiquement par une réaction Redox pour qu'elle reçoive du métal, les zones conductrices (2) de la couche galvanique inférieure étant activées chimiquement par enlèvement anodique et
- ensuite, on applique la couche galvanique supérieure (7) sur la couche intermédiaire (6).

4. Procédé de fabrication d'un composant de micromécanique selon l'une des revendications 1 à 3,
**caractérisé en ce que**
la couche pulvérisée (4) est du palladium.

5. Procédé de fabrication d'un composant micromécanique ayant les caractéristiques suivantes :
- le composant micromécanique comporte des couches superposées formées de matières métalliques, les couches s'accrochant au moins partiellement solidairement les unes aux autres et étant reliées les unes aux autres au moins pendant le procédé de fabrication par des couches intermédiaires (10), les couches intermédiaires étant constituées par au moins une couche pulvérisée (10), appliquée comme métallisation de départ sur la couche métallique (2) respectivement en dessous et sur laquelle on applique une couche galvanique métallique (7), au-dessus, procédé comprenant les étapes suivantes :
- on applique sur un substrat (1) comme couche de support une première couche avec des zones conductrices (2) et des zones non-conductrices (3),
- on applique une couche pulvérisée (10) en titane comme couche intermédiaire sur la première couche,
- on masque la couche pulvérisée (10) avec un résist (11),
- on enlève par attaque chimique la couche pulvérisée (10) dans les zones non masquées et ensuite on enlève le résist (10),
- dans des zones prédéterminées, on applique un autre résist (11a) et dans les zones entre l'autre résist (11a) on applique par galvanoplastie une couche galvanique supérieure (12), et
- dans une étape de fabrication ultérieure, on enlève le substrat (1), les zones non-conductrices (3) et le résist (11a) et on enlève, des zones conductrices (2), la couche galvanique supérieure (12) de la couche pulvérisée (10).

6. Procédé de fabrication d'un composant micromécanique selon la revendication 5,
**caractérisé en ce que**
le résist (11), utilisé comme masque pour la couche pulvérisée (10), est attaqué avec une photolaque (AZ-laque) traité avec des solvants et dans une solution d'acide fluorhydrique, les zones non-conductrices (3) de la couche de support étant en une matière plastique que l'on peut traiter dans un milieu alcalin aqueux.
